# EUROPEAN PATENT SPECIFICATION

(11) **EP 2 459 340 B1**
(45) Date of publication and mention of the grant of the patent: **12.08.2015**
(21) Application number: 09783248.9
(22) Date of filing: 21.09.2009
(51) Int. Cl.: B23K 1/00, B23K 1/002, B23K 3/047, B23K 3/08, H01L 31/05, H01L 31/18, H05B 6/02, H05B 6/36

(54) **INDUCTIVE SOLDERING DEVICE WITH AT LEAST ONE LOOP ELEMENT, HAVING TWO ARMS POSITIONED AT DIFFERENT DISTANCES FROM A SURFACE OF A WORKPIECE**
INDUKTIVLÖTGERÄT MIT MINDESTENS EINEM LEITUNGSSCHLEIFENELEMENT MIT ZWEI IN UNTERSCHIEDLICHEM ABSTAND VON EINER FLÄCHE EINES WERKSTÜCKES POSITIONIERTEN ARMEN
DISPOSITIF DE SOUDURE A INDUCTION COMPRENANT AU MOINS UN ELEMENT DE BOUCLE, DOTE DE DEUX BRAS POSITIONNES A DES DISTANCES DIFFERENTES DE LA SURFACE D'UNE PIECE DE TRAVAIL

(30) Priority: 31.07.2009 US 533234
(43) Date of publication of application: 06.06.2012
(73) Proprietor: Komax Holding AG, 6036 Dierikon (CH)
(72) Inventor: DINGLE, Brad M., Red Lion, PA 17356 (US); MICCICHE, Brian S., York, PA 17406 (US); SIDELINGER, Shawn M., York, PA 17408 (US); NEIDERT, Kenneth A., Lewisberry, PA 17339 (US); MEISSER, Claudio, 6330 Cham (CH)
(74) Representative: Blöchle, Hans
(86) International application number: PCT/EP2009/062209
(87) International publication number: WO 2011/012175

(56) References cited:
- EP-A1- 1 748 495
- EP-A1- 2 103 373
- JP-A- 6 297 137
- JP-A- 62 148 081

## Description

### FIELD OF THE INVENTION

The invention relates to a soldering apparatus, according to the preamble of claim 1 (see, for example, EP1 748 495 A1), used to generate heat for the soldering process to connect silicon solar cells with flat copper wires.

### BACKGROUND OF THE INVENTION

From Production of crystalline photovoltaic modules is done by electrically connecting groups of silicon solar cells. Typically, individual cells are connected by flat copper wires (ribbons) into electrical series arrangements known as strings. The cell to cell stringing connections are ordinarily done using a soldering process to attach the flat copper wires to the front and back surfaces of the cells.

A general concept of a method and apparatus for forming a solar cell string by inductive soldering is disclosed in EP 1 748 495 A1. From the patent specification EP 1 748 495 A1 a soldering apparatus for the electrical connection of a plurality of solar cells has become known wherein provided on the surface of the cells are conducting tracks which can have applied to them an electrically conducting strip. The strip, by means of a heat source, is electrically connectable with the conducting track, and by means of inductive heating the heat source heats the conducting tracks and strip and melts a soldering medium that connects the strip with the conducting tracks.

In a particular method of soldering, used on Komax stringing machines (Komax AG, Dierikon, Switzerland), the pre-tinned flat copper wires are kept in position by hold-down pins and the heat is generated by water-cooled inductive coils placed near the solar cell. The necessary hold-down pins and inductive coils for the soldering of one solar cell are combined in one device, the so called solder head. The vertically movable solder head is placed over an apparatus maintaining the alignment of the cells and the wires.

When the solder head is lowered, the vertically free movable hold-down pins provide the hold-down force by their weight. Depending on the dimension of the solar cell and the number of flat wires to be connected a considerable number of inductive coils and hold-down pins have to be integrated into the solder head. Each inductive coil needs associated control hardware for power supply and the cooling circuit.

Examples of Komax stringing machines are shown in U.S. Patent No. 6,510,940 B1 and U.S. Patent Application Publication No. 2006/0219352 A1.

Today's "standard" coil has openings through which the ceramic hold-down pins pass to allow fixing of the ribbon during soldering. Active portions of the coil are symmetrically located on each side of the ribbon, and the level of coil activity in the copper tubing cancels when the tubes come close together. The most active parts of the coil are therefore not over the ribbon such that a large amount of the energy developed is in the cell's metal layer, and not in the copper ribbon. This means that a significant amount of the heat generated has to flow through the cell to reach the ribbon, where it will melt the solder.

JP 62 148081 A shows an induction heating device having plural pieces of circular coil-shaped heating elements arranged on an arm.

JP 06 297137 A refers to an induction heating coil surroinding a tube to be joined on a joint.

### SUMMARY OF THE INVENTION

The present invention defines a soldering apparatus according to claim 1, that generates heat for the soldering process by the induction principle.

An advantage achieved by the invention is the reducing of the cell breakage rates by developing a coil that concentrates its energy into the copper ribbon as much as possible instead of into the metal layer of the solar cell. In this way, the soldering process can be improved by heating more directly the material that needs to receive the heat instead of heating the cell's metal layer and relying on the heat to flow from it. The benefit to users is that they can now solder with even less heat in the cell than with currently available coils.

Another advantage of the present invention is that it reduces the influence of the different thermal expansions of the silicon solar cells and the flat wires. This is achieved by arranging multiple coils orthogonal to the elongations of the flat wires. The coils are activated one after another with a time lag during the soldering process.

### DESCRIPTION OF THE DRAWINGS

The above, as well as other advantages of the present invention, will become readily apparent to those skilled in the art from the following detailed description of preferred embodiments when considered in the light of the accompanying drawings in which:
Fig. 1 is a schematic perspective view of a plurality of solar cells that are electrically connected into a cell string;
Fig. 2 is a perspective view of a soldering head with an inductor loop;
Fig. 3 is a perspective view the inductor loop shown in Fig. 2 with a pressure foot;
Fig. 4 is a perspective view and Fig. 5 is a plan view of the inductor loop shown in Fig. 3 whose effective length is settable;
Fig. 5a is a plan view of an alternative inductor loop as the one shown in Fig. 5;
Fig. 6 is an enlarged perspective view of the connecting piece of the inductor loop shown in Fig. 3;
Fig. 7 is a perspective view of a prior art soldering head having induction coils level with and parallel to the upper surface of the solar cell;
Fig. 8 is a perspective view an inductor coil according to the present invention in a lowered position;
Fig. 9 is a perspective view the inductor coil shown in Fig. 8 in an upper position;
Fig. 10 is an end elevation view of the inductor coil shown in Fig. 8;
Fig. 11 is a perspective view an alternate embodiment of an inductor coil according to the present invention;
Fig. 12 is an elevation view of the inductor coil shown In Fig. 11;
Fig. 13 is a perspective view of plurality of the inductor coils shown in Fig. 11 with coil holder blocks; and
Fig. 14 is a block diagram of a control system for multiple inductor coils according to the present invention.

### DESCRIPTION OF THE PREFERRED EMBODIMENT

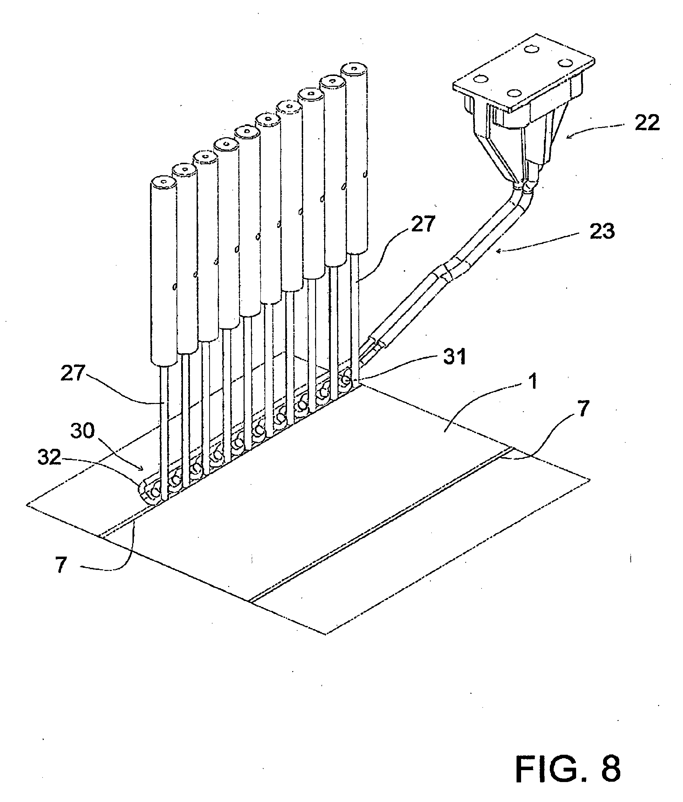

The following detailed description and appended drawings as from Figures 8-14 describe and illustrate various exemplary embodiments of the invention. The description and drawings serve to enable one skilled in the art to make and use the invention, and are not intended to limit the scope of the invention in any manner. In respect of the methods disclosed, the steps presented are exemplary in nature, and thus, the order of the steps is not necessary or critical.

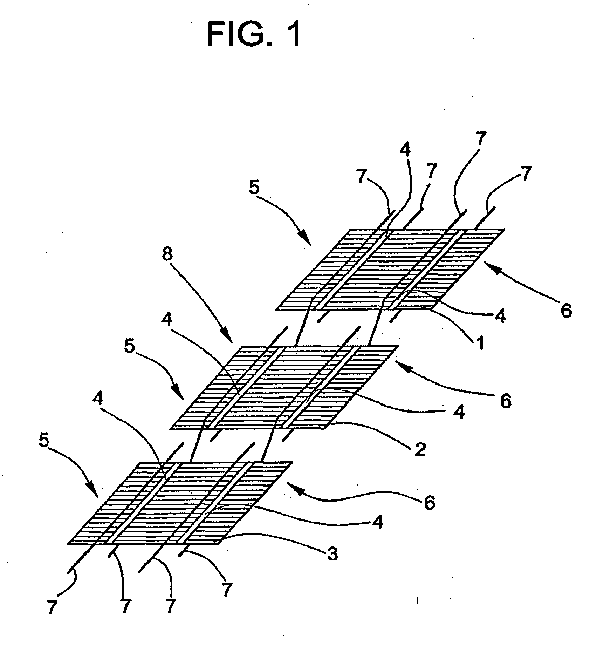

Fig. 1 shows a first solar cell **1,** a second solar cell **2,** and a third solar cell **3.** The solar cells **1, 2, 3** are also referred to as photovoltaic cells and convert the radiant energy contained in light into electrical energy. The voltage that is generated in the individual cells prevails between conducting tracks **4** of the cell upper side **5** and conducting tracks of the lower side **6** of the cell that are not visible in Fig. 1. If the conducting tracks **4** of the cell upper side **5** and the conducting tracks of the cell lower side **6** are connected in a circuit to an electric load, for example an ohmic resistance or battery, an electric current flows, and the energy that is generated by the solar cell is consumed in the load or stored in the battery respectively. A plurality of solar cells is electrically connected together into a string. A plurality of strings form a module, also referred to as a panel. On the conducting tracks **4** of the cell upper side **5,** and on the conducting tracks of the cell under side **6,** the solar cells are connected in series. The voltages of the individual cells thus add, and thinner conductors **7** can be used for connecting them together.

In Fig. **1** the first solar **cell 1,** the second solar cell **2,** and the third solar cell **3** are electrically connected together into a cell string **8.** A conductor **7** connects a conducting track **4** of the cell upper side **5 of** the first solar cell **1** with the conducting track of the cell lower side **6** of the second solar cell **2.** A conductor **7** connects a conducting track **4** of the cell upper side **5** of the second solar cell **2** with the conducting track of the cell lower side **6** of the third solar cell **3.**

The connection between the conducting track **4** and the conductor **7** is produced by means of a soldering operation, wherein a heat source heats the conductor **7** and the conducting track **4** that is provided with soldering medium, and the soldering medium, for example a soft solder, melts, the liquid soldering medium wetting the conducting track **4** and the conductor **7.** Under the effect of the heat, a solid electrically conducting connection comes into being between the conducting track **4** and the conductor **7.**

To produce the soldered connection, different types of heat generation can be used. As stated above, particularly advantageous is a heat source that operates on the induction principle, wherein a high-frequency generator generates a high-frequency current with a frequency of, for example, 800 kHz to 900 kHz in an inductor loop, which gives rise to a high-frequency magnetic field.

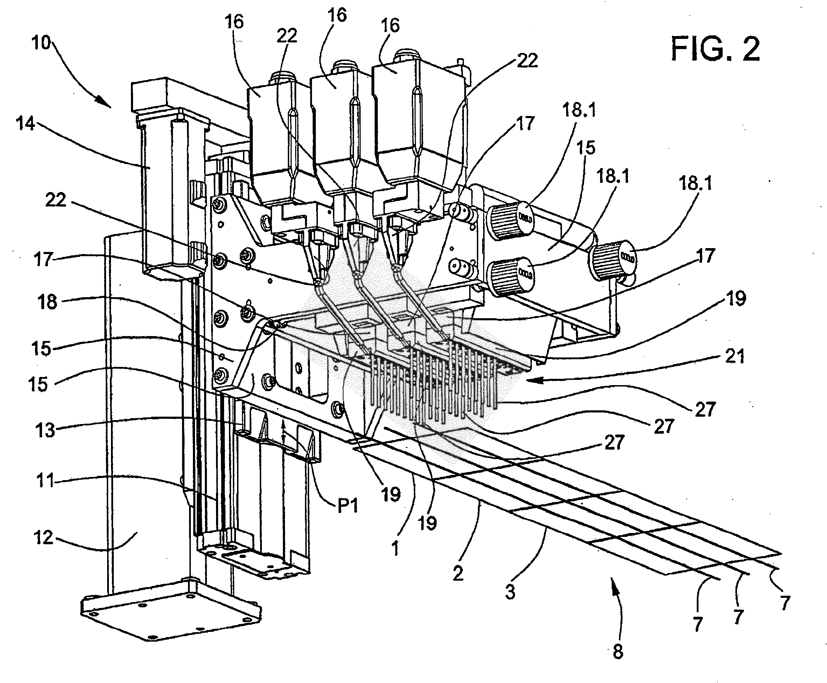

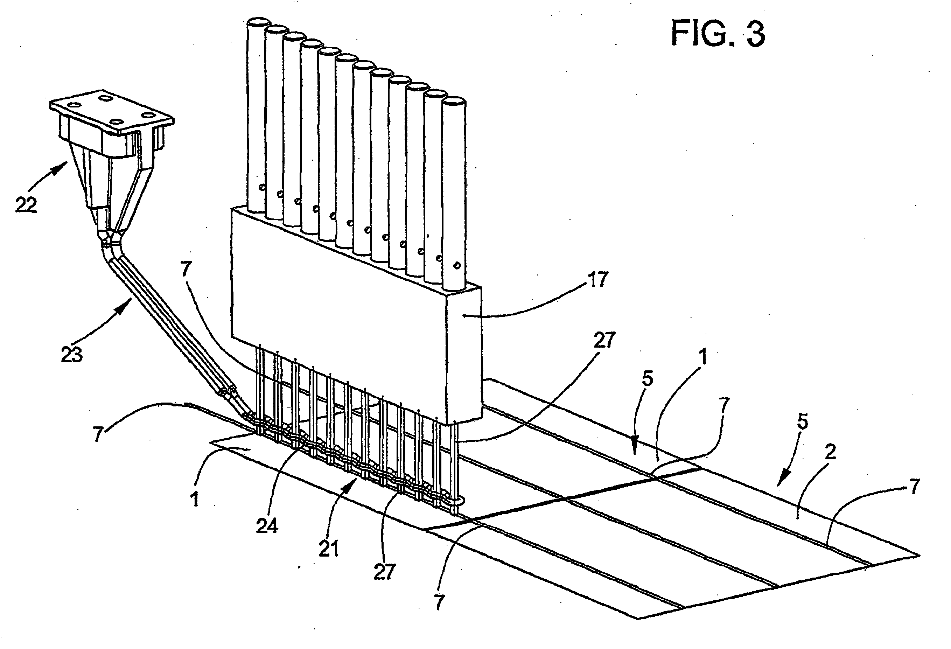

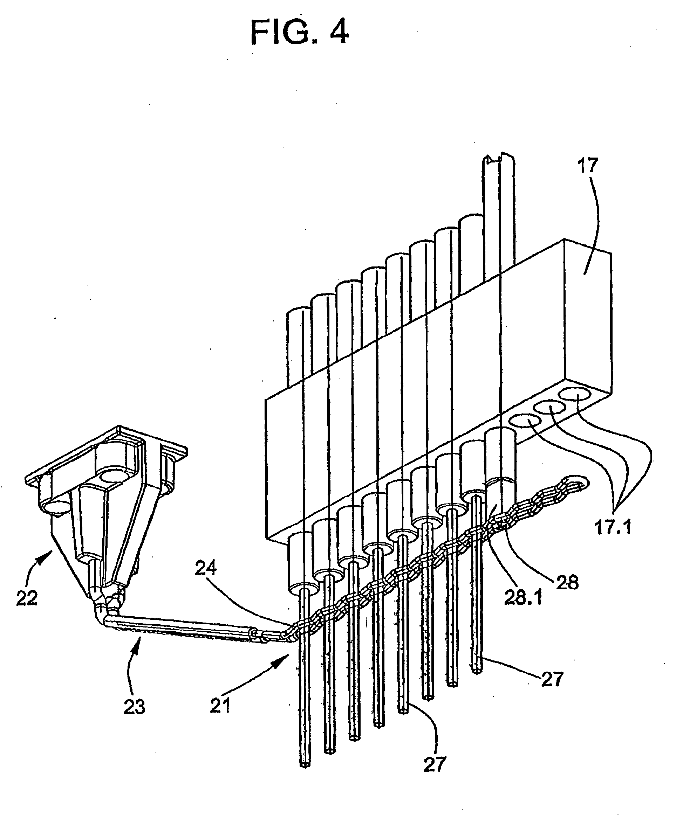

Fig. 2 shows a soldering head **10** equipped with three inductor loops **21.** A linear guide **11** is arranged on a stand **12,** the linear guide **11** of the guide serving as a slide **13** which, by means of a motor **14,** is movable up and down as symbolized with an arrow **P1.** The slide **13** serves as support for a housing **15,** arranged on which are connecting blocks **16,** guide blocks **17,** an adjusting spindle **18** for the inductor loops **21,** and pressure feet **27.** Provided for each inductor loop **21** is an adjusting spindle **18,** by means of which, with an adjusting nut **18.1,** the position of the inductor loop **21** and of the pressure foot **27** is manually alignable on the respective conducting track **4** of the solar cell. The loop element **24** is set into a plate **19,** for example of plastic, which is arranged on the guide block **17** (Fig. 3). Each pressure foot **27** is freely movable in a vertical drilled hole **17.1** in the guide block **17** (Fig. 4). When the soldering head **10** is lowered in the direction of the solar cell **1**, **2, 3,** the pressure feet **27** rest on the conductor **7** and, through their own weight, press the conductor **7** onto the conducting track **4.**

Fig. 2 shows the solar cells with three parallel conducting tracks **4.** With the soldering head **10** shown, by means of the three inductor loops **21** the three conducting tracks **4** can be soldered simultaneously along their entire cell length.

If solar cells with two conducting tracks **4** are processed or soldered, a connecting block **16,** a guide block **17** with the inductor loop **21** and the pressure foot **27** are removed. For solar cells with more than three conducting tracks **4,** the soldering head **10** can also be constructed larger than shown, and have more than three inductor loops **21.**

The connecting block **16** serves as a support for the inductor loop **21** and comprises the water connection, the electric connection, and the high-frequency generator for generating the high-frequency current in the inductor loop **21.**

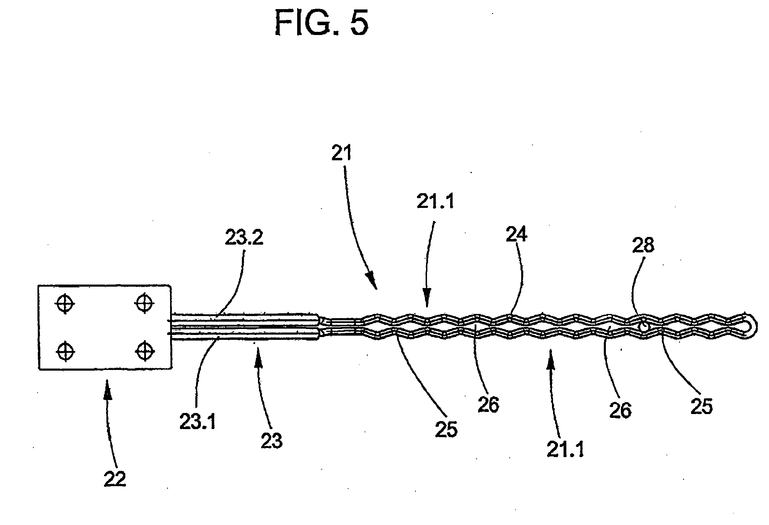

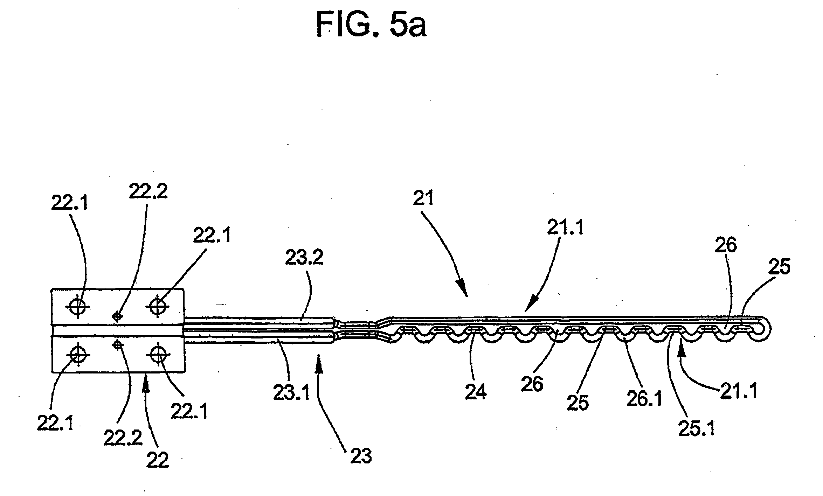

Fig. 3 shows an inductor loop **21,** without the plate **19,** that is arranged on the soldering head **10.** The inductor loop **21** consists of a connecting piece **22,** a feeder element **23,** and of a U-shaped loop piece **24,** at least one arm of the "U" being wavy. The feeder element **23** and the loop element **24** take the form of hollow conductors, and have flowing through them a coolant, for example water. The feeder element **23** consists of two tubes **23.1, 23.2** lying close to each other, which feed the coolant to the loop element **24** and drain it away from the loop element **24** (Fig. 5). The loop element **24** consists of a tube which is formed into a U-shape with two arms **21.1** and closely approximates to the form of a hairpin (Fig. 5). The free ends of the tube are connected with the tubes of the feeder element **23.** The tubes of the feeder element **23** and the tube of the loop element **24** are of electrically conducting material as, for example, copper. The U-shaped tube has, as indicated in Figs. 5, **5a****,** narrowings **25** and widenings **26.** As described further above, the narrowings **25** and widenings **26** serve to optimize the heat development in the solder zone, and thus also the saving of energy. Each widening **26** affords access to the soldering point for a magnetic-field-neutral pressure foot **27** of, for example, ceramic, which presses the conductor **7** onto the conducting track **4.** With the inductor loop **21** shown In Fig. 3, the entire length of the conducting track **4** of the cell upper side **5** of a solar cell **1, 2, 3** can be soldered to the conductor **7** in one soldering operation. The magnetic field of the inductor loop **21,** or more specifically the eddy currents in the conducting track **4** and in the conductor **7,** can also simultaneously heat the conducting track and the conductor, and melt the soldering medium of the cell lower side **6,** and produce a soldered joint between the conducting track **4** and the conductor **7.**

Fig. 4 and Fig. 5 show the inductor loop **21** whose effective length is settable. The dimensions of the loop element **24** correspond to the dimensions of the loop element **24** of Fig. 3. Depending on need, or depending on the size of the solar cell that is to be soldered, the effective length can be reduced. A screw **28** that is inserted in a widening **26,** or a bolt **28** that is inserted in a widening **26,** short-circuits the loop element **24.** The high-frequency current can flow from the high-frequency generator and generate a magnetic field only as far as the screw or bolt **28.** The screw or bolt **28** can be releasably connected with the soldering head and manually or mechanically inserted. The supernumerary pressure feet **27** have been removed, or **fixed** in a higher position, and a threaded bolt **28.1** for the screw **28** has been inserted in the widening **26** with the drilled hole **17.1** that corresponds to the screw **28.**

The form of the widenings **26** and of the narrowings **25** also depends on the manufacturing technology. Critical for optimization of the power consumption is mainly the alternatingly reduced and expanded distance between the tubes. In the example of Fig. 5, the bending radii of the widenings **26** and narrowings **25** are chosen large, so that the loop element **24** can be produced from one tube, in one piece, in one bending operation. If a shape is chosen with small bending radii, for example a zigzag shape, the loop element **24** must be assembled from individual elements for the widening **26** and narrowing **25.**

Fig. 5a shows the loop element **24** with a shape which, with respect to the bending radii, can still be produced with one bending operation. The tube, more specifically the one arm **21.1** of the U-shaped loop element **24, is** formed straight, and the other leg **21.1** of the loop element **24** is formed wavy with the widenings **26** and the narrowings **25.** Provided for the widenings **26** is an arc-shaped section **26.1,** and provided for the narrowings **25** is a straight section **25.1,** the pressure feet **27** fitting into the widenings **26.**

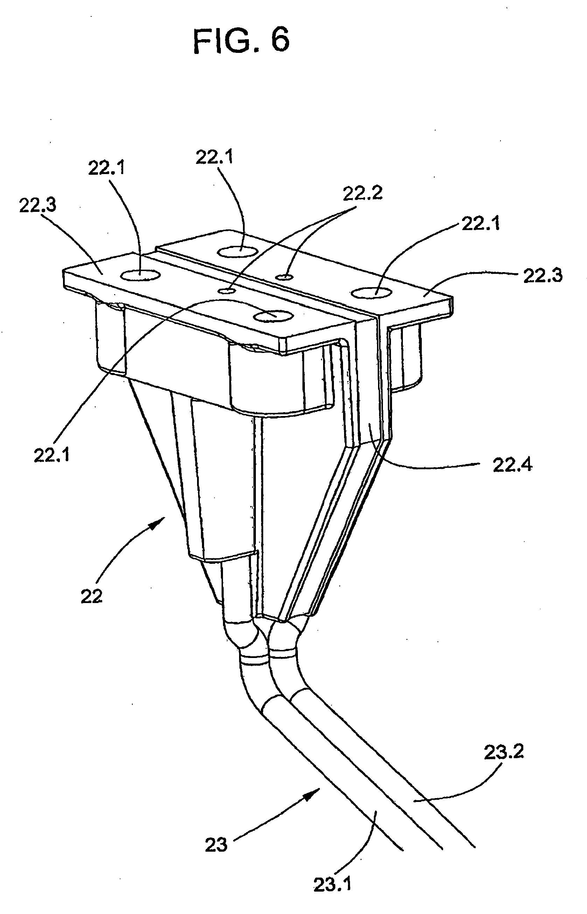

Fig. 6 shows details of the connecting piece **22** of the inductor loop **21.** The connecting piece **22** is releasably connected to the connecting block **16** by means of screws that penetrate drilled holes **22.1.** The water connection **22.2** is also connected to the connecting block **16** and is sealed by means of a not-shown O-ring at the connector-block end. The coolant circuit for cooling the loop element **24** is thus closed. Electrically, the connecting piece **22** is connected to the connecting block **16** by means of contact surfaces **22.3,** the contact surfaces **22.3** being electrically separated be means of an insulation plate **22.4.**

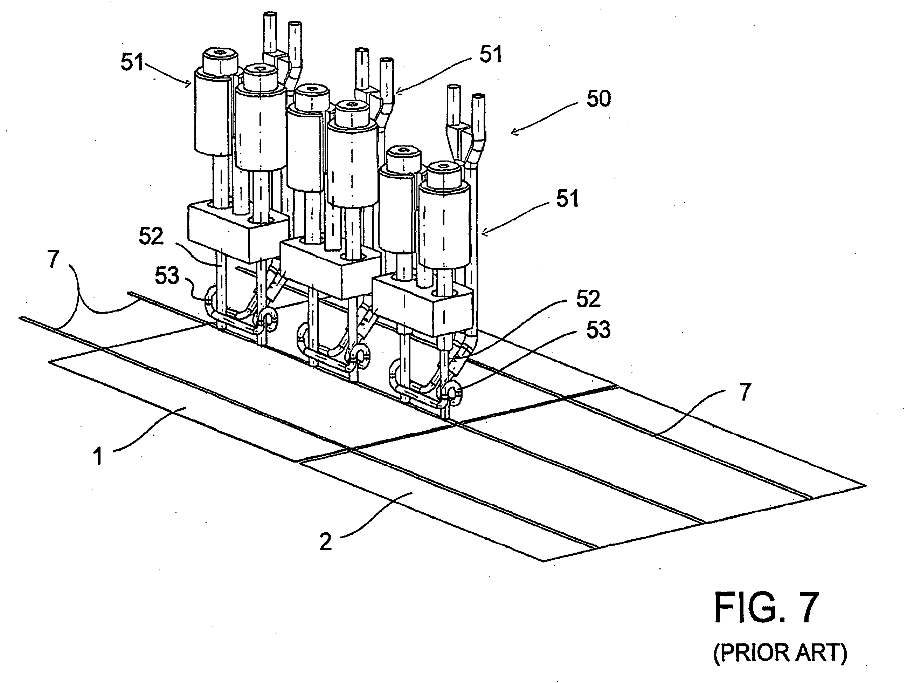

Fig. 7 shows a prior art soldering head **50** equipped with three connecting blocks **51.** Each connecting block **51** serves as a support for two hold-down pins or support feet **52** and an inductor loop or coil **53** and comprises the water connection, the electric connection, and the high-frequency generator for generating the high-frequency current in the inductor loop **53.**

The coil **53** has openings through which the ceramic hold-down pins **52** pass to allow fixing of the ribbon **7** during soldering. Active portions of the coil **53** are symmetrically located on each side of the ribbon **7,** and the level of coil activity in the copper tubing cancels when the tubes come close together. The most active parts of the coil are therefore not over the ribbon **7** such that a large amount of the energy developed is in the cell's metal layer, and not in the copper ribbon. This means that a significant amount of the heat generated has to flow through the cell **8** to reach the ribbon **7,** where it will melt the solder.

A feature of the present invention is an inductor loop or coil **30** (Fig. 8) having a loop element oriented at a 45 degree angle, in order to apply the heat to the ribbon or conductor **7** and still be able to use the ceramic hold-down pins **27.** This allows the pins to work between the active loops of the coil while keeping the rest of the coil far away from the cells **1, 2, 3.** Because the new coil **30** has less material in close proximity to the cell than the prior art coil, it is a bit less efficient. To improve the efficiency, a second feature of the present invention adds small beads **31** of ferrite material (flux concentrator) to the insides of each loop of a loop element **32** of the coil **30.** Fig. 8 shows the coil **30** in a lowered position for soldering.

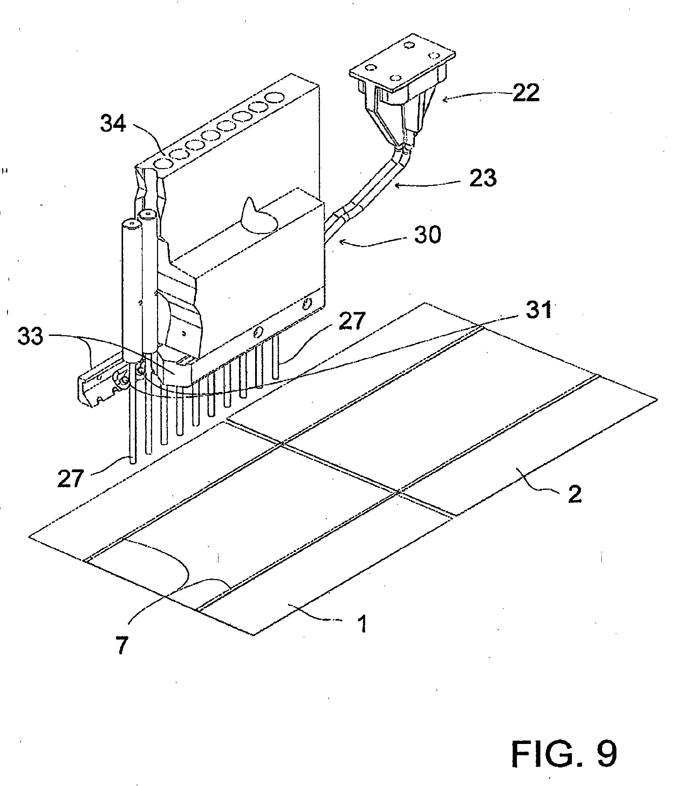

Fig. 9 shows the coil **30** in an upper or raised position in partial cut-away. The beads **31** are mechanically retained in a plastic coil holder block **33** positioned adjacent to a lower end of a guide block **34** for the pins **27.** In Fig. 8, the holder block **33** is shown in the lowered position adjacent to the upper surface of the cell **1.** The beads **31** function to effectively "force" current generated electromagnetic flux to the opposite side of the coil tube **32.** This extra concentration of electromagnetic flux is enough to make the coil's efficiency high enough to allow soldering of solar cells at roughly the same speed as the coil **21.**

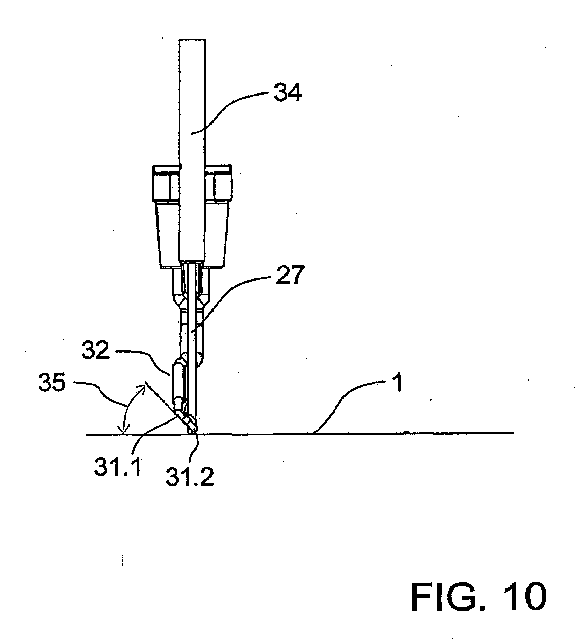

As shown in Figs. 3 and 5, the arms **21.1** of the coil **21** extend in a horizontal plane parallel to the facing surface of the cell **1.** As shown in Fig. 10, the coil **30** is oriented in a plane at a 45 degree angle **35** relative to the facing surface of the cell **1.** Similar to the loop element **24** shown in Fig. 5a, the loop element **31** has a straight arm **31.1** and an arm **31.2** with alternating narrowings and widenings. The arm **31.1** is higher than the arm **31.2** such that the widenings are closest to the conductor **7** to concentrate the energy.

The concentration of the energy provided by the inductive coil **30** in "spots" can be used to improve the soldering process. This feature of the present invention is the soldering of sections of more than one ribbon simultaneously when the coil is oriented orthogonally to the ribbons. For the soldering of the whole length of the ribbons several parallel coils are needed. These coils can be activated in a defined sequence to respect the different thermal expansions of the silicon solar cells and the ribbons.

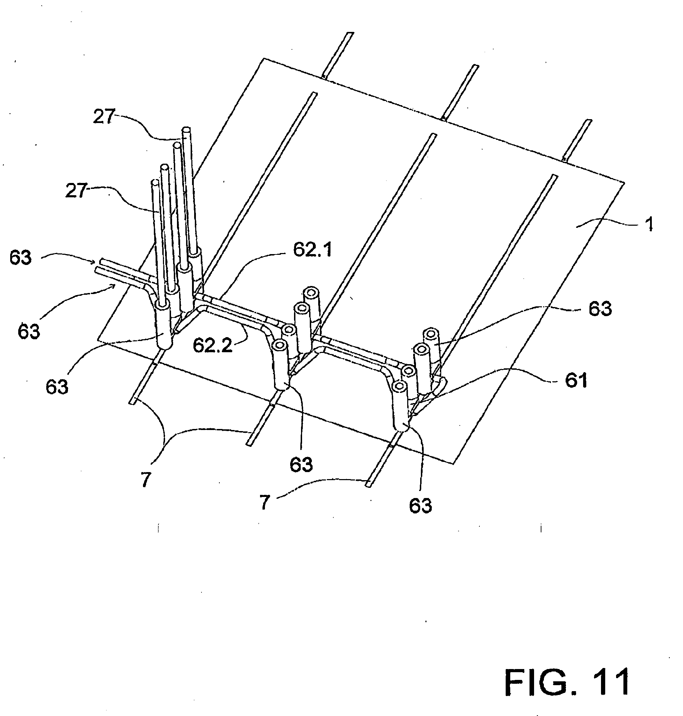

There is shown in Fig. 11 a second embodiment inductor coil **60** for simultaneously soldering sections of at least two of the conductors **7** when used with the connecting piece **22** and the feeder element **23.** As shown in Fig. 8 the loop element **32** of the first embodiment coil extends in a longitudinal direction parallel to the longitudinal axis of the conductor **7** being soldered. The coil **60** includes a loop element **62** that extends in a longitudinal direction that is transverse to the longitudinal axis of each of the conductors **7** being soldered. Because of the different orientation of the second type of the coil **60** there are two hold-down pins **27** for each arm of the loop element **62** at each conductor **7.** The hold-down pins **27** are placed in tubes **63** made of ferrite material. Ferrite beads **61** are placed between the tubes **63** to concentrate the energy in small spots.

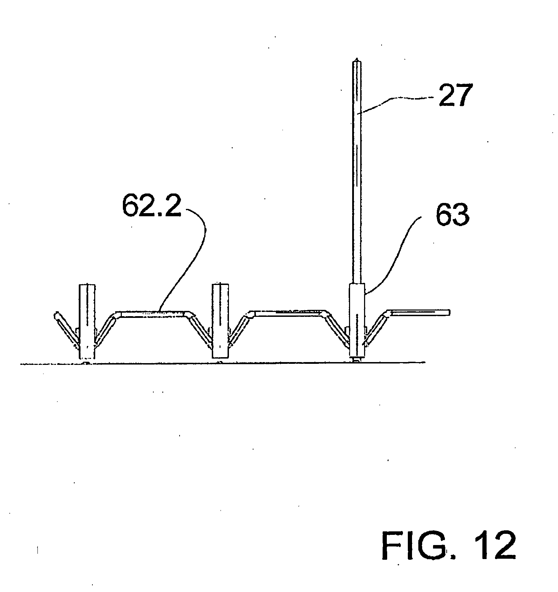

Similar to the first type coil **30,** the coil **60** is not oriented in a plane parallel to a solar **cell 1.** The loop element **62** has a straight arm **62.1** and an arm **62.2** with alternating narrowings and widenings. The loop element **62** is shaped to concentrate the heat in small regions by spacing the straight arm **62.1** and the narrowings of the arm **62.2** farther from the surface of the cell **1** than the widenings of the arm **62.2.** As shown in Fig. 12, the widenings of the arm **62.2** extend downwardly and closely adjacent to the surface of the cell **1.**

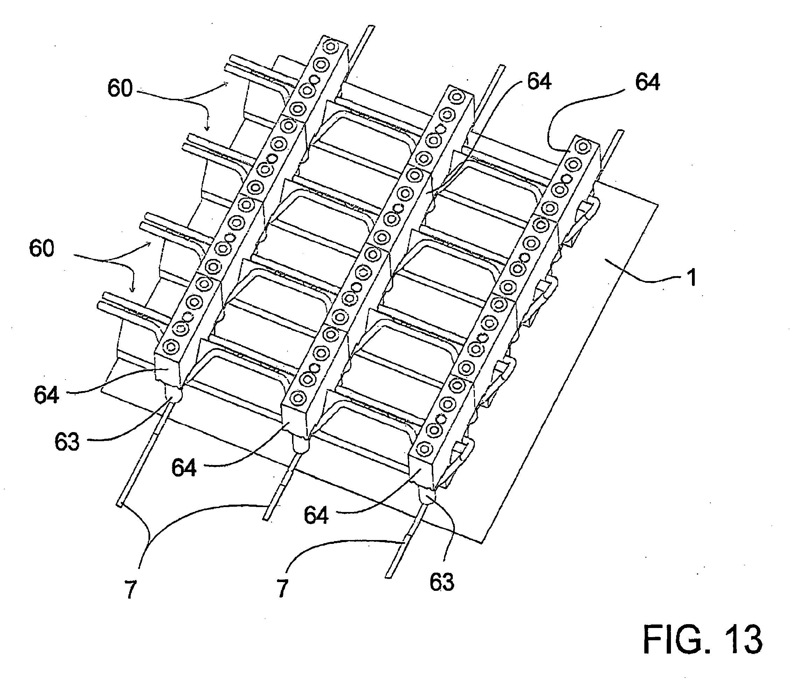

As shown in Fig. 13, a plurality of the coils **60** can be assembled to solder adjacent sections of three of the conductors **7.** Each group of four tubes **63** is mounted in a separate plastic coil holder block **64.** Although four coils **60** and blocks **64** are shown associated with each of three conductors 7, more or less coils, holders and conductors can be used.

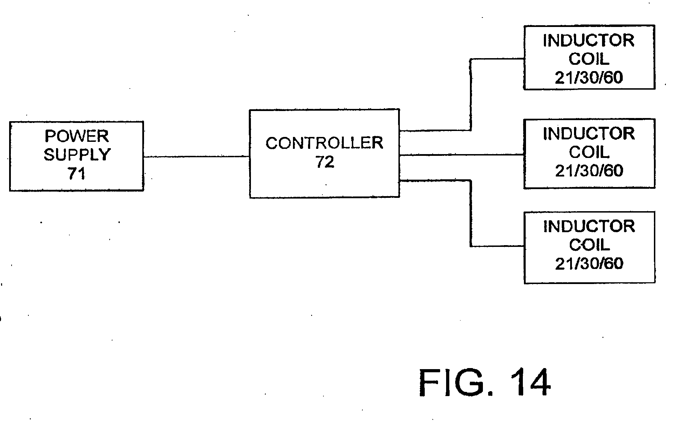

There is shown in Fig. 14 a control system **70** for selectively controlling multiple inductor coils **21, 30** and **60.** A power supply **71** is connected to an input of a controller **72** that has individual outputs connected to multiple inductor coils. Although three inductor coils are shown, any number can be connected to the controller **72.** The controller can be programmed to activate the coils selectively at different times to solve the problem of the different thermal expansions of the materials to be soldered. For example, if the coil **21** shown in Fig. 3 is replicated side-by-side for the three conductors **7,** the controller **72** can active the three coils simultaneously, or active the coils individually in a timed sequence, or activate two of the coils simultaneously and the other coil at a different time. This mode of operation can also be applied to two or more of the inductor coils **30** shown in Fig. 9.

As shown in Fig. 13, the longitudinal axes of the inductor coils **60** extend orthogonal to the longitudinal axes of the conductors **7.** As described above, the controller **72** can be operated to active the coils **60** in a timed sequence. For example, the controller **72** can active the four coils **60** sequentially, or active the coils individually or in combinations with any other timed sequence.

In accordance with the provisions of the patent statutes, the present invention has been described in what is considered to represent its preferred embodiment. However, it should be noted that the invention can be practiced otherwise than as specifically illustrated and described without departing from its scope as defined in the appended claims.

## Claims

1. A soldering apparatus for connecting solar cells (1, 2, 3) including a heat source that operates on the induction principle and connects conducting tracks (4) of the solar cells (1, 2, 3), that are provided with soldering medium, with electric conductors (7),
**characterised in that** the soldering apparatus comprises a plurality of hold-down pins (27), and an inductor loop connected (21) to a generator for receiving a high-frequency electrical current, wherein flowing of the high-frequency electrical current through said inductor loop (21) generates a high-frequency magnetic field, said inductor loop including a pair of arms (31.1, 31.2; 62.1, 62.2) extending along parallel longitudinal axes at different distances along a longitudinal direction of said hold-down pins (27), and in use, from the conducting track (4) to which the electric conductor (7) is to be soldered, a one of said arms (31.1, 31.2, 62.1, 62.2) having widenings and narrowings spaced along a length thereof wherein each said pin (27) extending between said arms (31.1, 31.2; 62.1, 62.2) at one of said widenings.

2. The soldering apparatus according to Claim 1 wherein said arms (31.1, 31.2; 62.1, 62.2) extend in a plane inclined approximately 45° relative to a surface to which the conductor is to be soldered.

3. The soldering apparatus according to Claim 1 including a bead (31) of ferrite material positioned at each said widening wherein flowing of the high-frequency electrical current through said inductor loop (21) generates a high-frequency magnetic field and said beads (31) concentrate the magnetic field at said widenings.

4. The soldering apparatus according to Claim 3 including a coil holder block (33) extending along a loop element (32, 62) and retaining said beads (31).

5. The soldering apparatus according to Claim 1 wherein said inductor loop (21) extends transverse to at least two conductors (7) the surface and wherein one of said widenings Is adjacent one of the conductors (7) and another of said widenings is adjacent another of the conductors (7).

6. The soldering apparatus according to Claim 5 including at each said widening one of said arms passes between a first pair of said hold-down pins (27) and another of said arms passes between a second pair of said hold-down pins (27).

7. The soldering apparatus according to Claim 6 including a tube (63) of ferrite material associated with each of said hold-down pins (27) and through which said associated hold-down pin (27) passes.

8. The soldering apparatus according to Claim 7 including a bead (61) of ferrite material positioned at each said widening wherein flowing of the high-frequency electrical current through said Inductor loop (21) generates a high-frequency magnetic field and said beads concentrate the magnetic field at said wldenings.

9. The soldering apparatus according to Claim 8 including a coil holder block (64) positioned at each said widening, said coil holders retaining said beads (61).

10. The soldering apparatus according to Claim 5 including a controller (72) connected to the generator wherein said inductor loop is a first inductor loop (21) and said first inductor loop (21) and at least a second inductor loop (30) extending parallel to said first inductor loop (21) are connected to said controller (72), said controller operating to supply the electrical current from the generator to said first Inductor loop (21) at a different time than to said second inductor loop (30).

11. A soldering apparatus according to one of claims 1 to 10, comprising:
a second inductor loops (30, 60) connected to the generator for receiving a high-frequency electrical current, wherein flowing of the high-frequency electrical current through said inductor loops (30, 60) generates a high-frequency magnetic field, said second inductor loop (30, 60) including a pair of arms (62.1, 62.2) extending along parallel longitudinal axes at different distances along a longitudinal direction of said hold-down pins (27), and, in use, from the conducting track (4) to which the electric conductor is to be soldered, a one of said arms (62.1, 62.2) having widenings and narrowings spaced along a length thereof;
wherein each said pin (27) extending between said arms (31.1, 31.2; 62.1, 62.2) at one of said widening; and
a controller (72) connected between said generator and said first and second inductor loops (31, 30, 60) and operating to supply the electrical current from said generator to said first inductor loop (30) at a different time than to said second inductor loop (60).

## Patentansprüche

1. Lötgerät zum Verbinden von Solarzellen (1, 2, 3), enthaltend eine Wärmequelle, die nach dem Induktionsprinzip arbeitet und Leiterbahnen (4) der Solarzellen (1, 2, 3), die mit Lötmittel versehen sind, mit elektrischen Leitern (7) verbindet,
**dadurch gekennzeichnet, dass** das Lötgerät mehrere Niederhaltestifte (27) und eine Induktorschleife (21) aufweist, die mit einem Generator zum Empfangen eines Hochfrequenzstroms verbunden ist, wobei ein Strom des Hochfrequenzstroms durch die Induktorschleife (21) ein Hochfrequenzmagnetfeld erzeugt, wobei die Induktorschleife (21) ein Paar von Armen (31.1, 31.2; 62.1, 62.2) enthält, die sich entlang paralleler Längsachsen mit unterschiedlichem Abstand entlang einer Längsrichtung der Niederhaltestifte (27) und, in Verwendung, von der Leiterbahn (4), an die der elektrische Leiter (7) gelötet werden soll, erstrecken, wobei einer der Arme (31.1, 31.2; 62.1, 62.2) Erweiterungen und Verengungen aufweist, die entlang seiner Länge beabstandet sind,
wobei sich jeder Stift (27) zwischen den Armen (31.1, 31.2; 62.1, 62.2) an einer der Erweiterungen erstreckt.

2. Lötgerät nach Anspruch 1, wobei sich die Arme (31.W1, 31.2; 62.1, 62.2) in einer Ebene erstrecken, die etwa 45° relativ zu einer Fläche geneigt ist, an die der Leiter gelötet werden soll.

3. Lötgerät nach Anspruch 1, das einen Wulst (31) Ferritmaterial enthält, der an jeder Erweiterung positioniert ist, wobei ein Strom des Hochfrequenzstroms durch die Induktorschleife (21) ein Hochfrequenzmagnetfeld erzeugt und die Wülste (31) das Magnetfeld an den Erweiterungen konzentrieren.

4. Lötgerät nach Anspruch 3, enthaltend einen Spulenhalterungsblock (33), der sich entlang eines Schleifenelements (32, 62) erstreckt und die Wülste (31) hält.

5. Lötgerät nach Anspruch 1, wobei sich die Induktorschleife (21) quer zu mindestens zwei Leitern (7) auf der Fläche erstreckt und wobei eine der Erweiterungen neben einem der Leiter (7) liegt und eine andere der Erweiterungen neben einem anderen der Leiter (7) liegt.

6. Lötgerät nach Anspruch 5, enthaltend an jeder Erweiterung einen der Arme, der zwischen einem ersten Paar der Niederhaltestifte (27) hindurchgeht, und einen anderen der Arme, der zwischen einem zweiten Paar der Niederhaltestifte (27) hindurchgeht.

7. Lötgerät nach Anspruch 6, enthaltend ein Rohr (63) aus Ferritmaterial, das jedem der Niederhaltestifte (27) zugeordnet ist und durch das der zugeordnete Niederhaltestift (27) hindurchgeht.

8. Lötgerät nach Anspruch 7, enthaltend einen Wulst (61) aus Ferritmaterial, der an jeder Erweiterung positioniert ist, wobei ein Strom des Hochfrequenzstroms durch die Induktorschleife (21) ein Hochfrequenzmagnetfeld erzeugt und die Wülste das Magnetfeld an den Erweiterungen konzentrieren.

9. Lötgerät nach Anspruch 8, enthaltend einen Spulenhalterungsblock (64), der an jeder Erweiterung positioniert ist, wobei die Spulenhalter die Wülste (61) halten.

10. Lötgerät nach Anspruch 5, enthaltend eine Steuerung (72), die mit dem Generator verbunden ist, wobei die Induktorschleife eine erste Induktorschleife (21) ist und die erste Induktorschleife (21) und zumindest eine zweite Induktorschleife (30), die sich parallel zur ersten Induktorschleife (21) erstreckt, mit der Steuerung (72) verbunden sind, wobei die Steuerung zum Zuleiten des Stroms vom Generator zur ersten Induktorschleife (21) zu einer anderen Zeit als zur zweiten Induktorschleife (30) arbeitet.

11. Lötgerät nach einem der Ansprüche 1 bis 10, enthaltend:
eine zweite Induktorschleife (30, 60), die mit dem Generator zum Empfangen eines Hochfrequenzstroms verbunden ist, wobei der Strom des Hochfrequenzstroms durch die Induktorschleifen (30, 60) ein Hochfrequenzmagnetfeld erzeugt, wobei die zweite Induktorschleife (30, 60) ein Paar von Armen (62.1, 62.2) enthält, die sich entlang paralleler Längsachsen mit unterschiedlichem Abstand entlang einer Längsrichtung der Niederhaltestifte (27) und, in Verwendung, von der Leiterbahn (4), an die der elektrische Leiter gelötet werden soll, erstrecken, wobei einer der Arme (62.1, 62.2) Erweiterungen und Verengungen aufweist, die entlang seiner Länge beabstandet sind;
wobei sich jeder Stift (27) zwischen den Armen (31.1, 31.2; 62.1, 62.2) an einer der Erweiterungen erstreckt; und
eine Steuerung (72), die zwischen dem Generator und der ersten und zweiten Induktorschleife (21, 30, 60) verbunden ist und zum Zuleiten des Stroms vom Generator zur ersten Induktorschleife (30) zu einer anderen Zeit als zur zweiten Induktorschleife (60) arbeitet.

## Revendications

1. Appareil de soudage pour relier des cellules solaires (1, 2, 3), comprenant une source de chaleur qui fonctionne selon le principe de l'induction et relie des pistes conductrices (4) des cellules solaires (1, 2, 3) pourvues d'un agent de soudage, avec des conducteurs électriques (7),
**caractérisé en ce que** l'appareil de soudage comprend plusieurs tiges de retenue verticale (27) et une boucle d'inducteur (21) reliée à un générateur pour recevoir un courant électrique haute fréquence, étant précisé que le passage du courant électrique haute fréquence dans ladite boucle d'inducteur (21) génère un champ magnétique haute fréquence, la boucle d'inducteur (21) contenant deux bras (31.1, 31.2 ; 62.1, 62.2) qui s'étendent le long d'axes longitudinaux parallèles, à des distances différentes, le long d'une direction longitudinale des tiges de retenue (27) et lors d'une utilisation, de la piste conductrice (4) à laquelle le conducteur électrique (7) doit être soudé, l'un des bras (31.1, 31.2 ; 62.1, 62.2) présentant des parties élargies et des parties rétrécies espacées sur sa longueur, étant précisé que chaque tige (27) s'étend entre les bras (31.1, 31.2 ; 62.1, 62.2) au niveau de l'une desdites parties élargies.

2. Appareil de soudage selon la revendication 1, étant précisé que les bras (31.1, 31.2 ; 62.1, 62.2) s'étendent dans un plan incliné d'environ 45° par rapport à une surface à laquelle le conducteur doit être soudé.

3. Appareil de soudage selon la revendication 1, comprenant un renflement (31) de matériau en ferrite placé dans chaque partie élargie, étant précisé que le passage du courant électrique haute fréquence dans la boucle d'inducteur (21) génère un champ magnétique haute fréquence et que les renflements (31) concentrent le champ magnétique au niveau des parties élargies.

4. Appareil de soudage selon la revendication 3, comprenant un bloc porte-bobine (33) qui s'étend le long d'un élément de boucle (32, 62) et qui retient les renflements (31).

5. Appareil de soudage selon la revendication 1, étant précisé que la boucle d'inducteur (21) s'étend transversalement par rapport à au moins deux conducteurs (7) sur la surface, et que l'une des parties élargies est voisine de l'un des conducteurs (7) tandis qu'une autre partie élargie est voisine d'un autre conducteur (7).

6. Appareil de soudage selon la revendication 5, comprenant au niveau de chaque partie élargie l'un des bras qui passe entre une première paire de tiges de retenue (27), et un autre bras qui passe entre une seconde paire de tiges de retenue (27).

7. Appareil de soudage selon la revendication 6, comprenant un tube (63) de matériau de ferrite, associé à chacune des tiges de retenue (27), qui est traversé par la tige de retenue (27) associée.

8. Appareil de soudage selon la revendication 7, comprenant un renflement (61) de matériau de ferrite qui est placé au niveau de chaque partie élargie, étant précisé que le passage du courant électrique haute fréquence dans la boucle d'inducteur (21) génère un champ magnétique haute fréquence, et que les renflements concentrent le champ magnétique au niveau des parties élargies.

9. Appareil de soudage selon la revendication 8, comprenant un bloc porte-bobine (64) qui est placé au niveau de chaque partie élargie, les porte-bobine retenant les renflements (61).

10. Appareil de soudage selon la revendication 5, comprenant un dispositif de commande (72) relié au générateur, étant précisé que la boucle d'inducteur est une première boucle d'inducteur (21) et que ladite première boucle d'inducteur (21) et au moins une deuxième boucle d'inducteur (30) parallèle à celle-ci sont reliées au dispositif de commande (72), ce dernier fonctionnant pour fournir le courant électrique, à partir du générateur, à la première boucle d'inducteur (21) à un moment différent par rapport à la deuxième boucle d'inducteur (30).

11. Appareil de soudage selon l'une des revendications 1 à 10, comprenant
une deuxième boucle d'inducteur (30, 60) reliée au générateur pour recevoir un courant électrique haute fréquence, étant précisé que le passage du courant électrique haute fréquence dans ladite boucle d'inducteur (30, 60) génère un champ magnétique haute fréquence, la deuxième boucle d'inducteur (30, 60) comprenant deux bras (62.1, 62.2) qui s'étendent le long d'axes longitudinaux parallèles, à des distances différentes, le long d'une direction longitudinale des tiges de retenue (27), et lors d'une utilisation, de la piste conductrice (4) à laquelle le conducteur électrique doit être soudé, l'un des bras (62.1, 62.2) présentant des parties élargies et des parties rétrécies espacées sur sa longueur, chaque tige (27) s'étendant entre les bras (31.1, 31.2 ; 62.1, 62.2) au niveau de l'une desdites parties élargies, et
un dispositif (72) monté entre le générateur et les première et deuxième boucles d'inducteur (21, 30, 60) et fonctionnant pour fournir le courant électrique, à partir du générateur, à la première boucle d'inducteur (30) à un moment différent par rapport à la deuxième boucle d'inducteur (60).
